## Europäisches Patentamt

## European Patent Office

## Office européen des brevets

(11) Veröffentlichungsnummer: **0 239 664 B1**

# EUROPÄISCHE PATENTSCHRIFT

(45) Veröffentlichungstag der Patentschrift: **18.12.91**

(51) Int. Cl.⁵: **C23C 16/40**

(21) Anmeldenummer: **86104596.1**

(22) Anmeldetag: **04.04.86**

(54) Verfahren zum Herstellen von Silicium und Sauerstoff enthaltenden Schichten.

(43) Veröffentlichungstag der Anmeldung:
**07.10.87 Patentblatt 87/41**

(45) Bekanntmachung des Hinweises auf die Patenterteilung:
**18.12.91 Patentblatt 91/51**

(84) Benannte Vertragsstaaten:
**DE FR GB**

(56) Entgegenhaltungen:

| | |
|---|---|
| DE-A- 1 646 004 | FR-A- 1 385 677 |
| FR-A- 2 332 338 | GB-A- 1 165 575 |
| GB-A- 2 132 230 | US-A- 3 158 505 |
| US-A- 3 934 060 | |

JOURNAL OF THE ELECTROCHEMICAL SOCIETY, Band 118, Nr. 9, September 1971, Seiten 1540-1542; J. WONG et al.: "Chemical vapor deposition of arsenosilicate glass: A one-liquid-source system"

IBM TECHNICAL DISCLOSURE BULLETIN, Band 8, Nr. 8, Januar 1966, Seite 1141, New York, US; W. HOFFMEISTER et al.: "Producing doped silicon dioxide layers"

(73) Patentinhaber: **IBM DEUTSCHLAND GMBH**
**Pascalstrasse 100**
**W-7000 Stuttgart 80(DE)**

(84) Benannte Vertragsstaaten:
**DE**

Patentinhaber: **International Business Machines Corporation**
**Old Orchard Road**
**Armonk, N.Y. 10504(US)**

(84) Benannte Vertragsstaaten:
**FR GB**

(72) Erfinder: **Biro, Laszlo**
**Pfarrwiesenallee 5/1**
**W-7032 Sindelfingen(DE)**
Erfinder: **Malin, Konrad**
**Sandstrasse 30**
**W-7405 Dettenhausen(DE)**
Erfinder: **Schmid, Otto**
**Gartenstrasse 77**
**W-7038 Holzgerlingen(DE)**

(74) Vertreter: **Mönig, Anton, Dipl.-Ing.**
**IBM Deutschland GmbH Patentwesen und Urheberrecht Schönaicher Strasse 220**
**W-7030 Böblingen(DE)**

## Beschreibung

Die Erfindung betrifft ein Verfahren zum Herstellen von Silicium und Sauerstoff enthaltenden Schichten mittels chemischen Niederschlagens aus der Dampfphase auf Substraten bei vermindertem Druck, wobei als Quelle für Silicium und Sauerstoff dienendes Tetraethylorthosilikat (TEOS) über die auf eine festgelegte Temperatur erhitzten Substrate geleitet wird.

Ein solches Verfahren ist z.B. aus dem Artikel "Pyrolytic Deposition of Silicon Dioxide in an Evacuated System" von J. Oroschnik und J. Kraitchman, veröffentlicht im Journal of the Electrochemical Society, Band 115, Nr. 6, Juni 1968, Seiten 649 ff. bekannt. Es ist bei diesem Verfahren, bei dem dampfförmiges TEOS in den evakuierten Reaktionsraum eingesaugt wird, jedoch so, daß einigermaßen homogene Schichtdicken auf den einzelnen Substraten und über eine größere Anzahl von Substraten nur erhalten werden, wenn man sich mit einer geringen Niederschlagsgeschwindigkeit begnügt. Außerdem ist es schwierig, festgelegte Schichtdicken reproduzierbar zu erzeugen. Dieses bekannte Verfahren kann auch dazu benutzt werden, indem man außer dem TEOS auch noch gasförmige Substanzen einsaugt, welche andere Elemente, wie z.B. Phosphor und/oder Bor enthalten, um Schichten, welche außer Silicium und Sauerstoff auch noch solche andere Elemente enthalten, herzustellen (siehe den Artikel "Measurements of Temperature Dependent Stress of Silicon Oxide Films Prepared by a Variety of CVD Methods" von G. Smolinski und T.P.H.F. Wendling, erschienen im Journal of the Electrochemical Society, Band 132, Nr. 4, April 1985, Seiten 950 ff.). Auch bei dieser Variation des bekannten Verfahrens treten die genannten Probleme mit der Homogenität und Reproduzierbarkeit auf. Diese genannten Probleme sind offenbar bei der Herstellung von nur Silicium und Sauerstoff enthaltenden Schichten darauf zurückzuführen, daß die in erster Linie von der Temperatur des Quellenmaterials, also des TEOS, abhängige Dampfmenge über dem flüssigen TEOS schwer zu steuern ist. Die Steuerbarkeit des Verfahrens wird weiter durch die beachtliche vom herrschenden Vakuum abhängige Volumenexpansion erschwert, welche der TEOS-Dampf beim Eintritt in den Niederdruckbereich der Vorrichtung erfährt. Es kommt hinzu daß es in dem flüssigen TEOS, welches ja über Ventile mit dem Niederdruckbereich in Verbindung steht, immer wieder zu unkontrollierten Siedeverzügen kommt, bei welchen plötzlich und kurzfristig große Mengen TEOS unkontrolliert in den Niederdruckbereich gelangen. Die genannten Schwankungen der TEOS-Mengen, welche in den Niederdruckbereich der Vorrichtung gelangen, führt zu Schwankungen des TEOS-Angebots am Ort der Substrate während des Aufwachsens, was nicht nur die Reproduzierbarkeit der Aufwachsgeschwindigkeit beeinträchtigt, sondern auch lokal zu unterschiedlichen Reaktionsbedingungen und damit auch zu unterschiedlichen Aufwachsgeschwindigkeiten führen.

Bei der Herstellung von zusätzlich noch anderen Materialien enthaltenden Schichten treten die oben beschriebenen Schwierigkeiten nicht nur bezüglich eines Quellenmaterials sonders bezüglich zweier oder dreier Quellmaterialien auf, so daß zu der schlechten Reproduzierbarkeit und der Inhomogenität der Schichtdicke noch eine schlechte Reproduzierbarkeit und eine Inhomogenität der Schichtzusammensetzung hinzukommt.

Es ist deshalb die Aufgabe der Erfindung, ein Verfahren um Schichten einheitlicher Schichtdicke und Zusammensetzung auf Substraten innerhalb kleiner Toleranzen reproduzierbar unter fabrikmäßigen Fertigungsbedingungen und mit dort brauchbaren Aufwachsgeschwindigkeiten herzustellen.

Diese Aufgabe wird mit einem Verfahren der eingangs genannten Art mit dem Merkmal des kennzeichnenden Teils des Patentanspruchs 1 gelöst.

Die erfindungsgemäß hergestellten Schichten sind nicht nur über die einzelnen Substrate, sondern über Chargen mit einer großen Anzahl von Substraten homogen. Die Regelung ist dabei sehr einfach und erfordert keinen höheren Aufwand als bei den bekannten Verfahren. Die hergestellten Schichten habe eine hohe Qualität und sind beispielsweise frei von Trübungen und haben die Eigenschaftem von thermischem Oxyd.

Zur Herstellung von Schichten, welche zusätzlich zu Silicium und Sauerstoff noch mindestens ein weiteres Element enthalten, wird dem TEOS in vorteilhafter Weise mindestens ein Material, welches das zusätzlich einzubauende Element enthält, zugemischt. D.h., daß der apparative Aufwand sogar noch geringer ist als bei der Herstellung von Mehrkomponentenschichten gemäß den bekannten Verfahren, bei welchen die Quellmaterialien getrennt in die Reaktionszone eingesaugt werden. Der Zusammenhang zwischen der Zusammensetzung des flüssigen Gemisches von Reaktanden und der Zusammensetzung der aufwachsenden Schicht läßt sich durch einfache Versuche ermitteln. Die so hergestellten Schichten sind nicht nur bezüglich der Schichtdicke, sondern vor allem aber auch bezüglich der Zusammensetzung sowohl über die einzelnen Substrate als auch über Chargen mit vielen Substraten beachtlich homogen.

Weitere vorteilhafte Ausgestaltungen des erfindungsgemäßen Verfahrens sind in den Unteransprüchen angegeben.

Die Erfindung wird anhand von durch Zeichnungen erläuterten Ausführungsbeispielen beschrieben.

Es zeigen:

Fig. 1    in schematischer Querschnittsdarstellung eine zur Durchführung des erfindungsgemäßen Verfahrens geeignete Vorrichtung,

Fig. 2    in einem Diagramm die Aufwachsgeschwindigkeit einer Silicium und Sauerstoff enthaltenden Schicht aufgetragen gegen den Partialdruck des TEOS am Ort der Abscheidung bei 730° C und

Fig. 3    in einem Diagramm den Gesamtdruck eines Gemisches aus TEOS, Triethylphosphit und Trimethylborat am Ort der Abscheidung bei 730° aufgetragen gegen die Fließgeschwindigkeit des flüssigen Gemischs der Reaktanden.

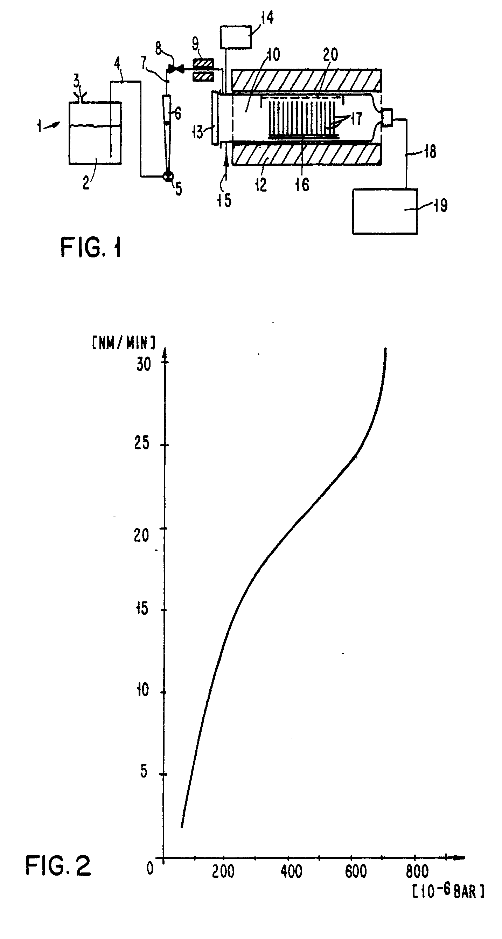

Zur Durchführung des erfindungsgemäßen Verfahrens ist eine Vorrichtung, wie sie die Figur 1 zeigt, geeignet, jedoch sind auch andere Ausbildungen der Vorrichtung denkbar.

Die Vorrichtung weist ein Quellengefäß 1 auf, in welches durch den Einfüllstutzen 3 die flüssige Quelle 2 eingefüllt wird. Ein Rohr 4 reicht bis in die Nähe des Bodens des Quellengefäßes 1, so daß es, wenn das Quellenmaterial eingefüllt ist, in dieses eintaucht. An das Rohr 4 schließen sich ein Nadelventil 5 und ein Flußmeter 6 an. Das Nadelventil 5 dient zur Dosierung der Menge an flüssigem Quellenmaterial, welche in den Niederdruckbereich pro Zeiteinheit eingesaugt wird. Der Niederdruckbereich beginnt am Nadelventil 5. An den Flußmeter 6 schließt sich ein Rohr 7 an, durch welches das Quellenmaterial in das Reaktionsrohr 10 geleitet wird. In das Rohr 7 kann ein "normalerweise geschlossenes" Durchlaßventil 8 eingebaut sein, mit dem der Zufluß von Quellenmaterial gesperrt oder gestattet werden kann. Gegebenenfalls wird das Rohr 7 durch einen Vorerhitzer 9 geführt, in dem das Quellenmaterial vollständig verdampft wird. Das Reaktionsrohr 10 ist ein zylindrisches Rohr, dessen Durchmesser durch die Abmessungen der Substrate 17, wie z.B. Halbleiterplättchen, bestimmt ist. Das Reaktionsrohr 10 ist an seinem einen Ende vakuumdicht mit der Tür 13 verschlossen. An seinem anderen Ende erfolgt die Absaugung mittels der Pumpe 19 über das Rohr 18. Die Pumpe 19 besteht beispielsweise aus einer von einer Vorpumpe und einer Rootspumpe gebildeten Pumpenkombination mit einer Saugleistung von ungefähr 240 m³ pro Stunde. Zum Beschicken des Reaktionsrohrs 10 mit dem Boot 16, welches die Substrate 17 enthält, kann die Tür 13 geöffnet werden. Mittels des Druckmessers 14 wird der Druck im Reaktionsrohr 10 gemessen. Zum Einleiten irgendwelcher Gase in das Reaktionsrohr 10 ist die Zuführung 15 vorgesehen. Das Reaktionsrohr 10 ist mit einem Rohrofen 12 umgeben, mit dem die notwendige Wärme im Reaktionsrohr 10 erzeugt wird.

Im folgenden soll das Verfahren zur Herstellung von nur Silicium und Sauerstoff enthaltenden Schichten unter Verwendung der in der Figur 1 gezeigten Vorrichtung genauer besprochen werden. Eine eventuell - vor der Durchführung des Verfahrens - notwendige Reinigung des Reaktionsrohrs 10 wird mit HCl-Gas durchgeführt, welches durch das Einlaßrohr 15 in das Reaktionsrohr 10 eingeleitet und durch das Rohr 18 abgesaugt wird. In einem festgelegten Bereich des sauberen Reaktionsrohrs 10 wird ein Boot 16 mit Halbleiterplättchen als Substraten 17 gestellt. Anschließend wird, nachdem zunächst mit Stickstoff gespült worden ist, evakuiert und die gewünschte Temperatur im Reaktionsrohr 10 eingestellt. Die Temperatur liegt bevorzugt im Bereich zwischen etwa 700 und etwa 750° C und bevorzugt bei etwa 730° C. Festlegung der Temperatur innerhalb des genannten Temperaturbereichs bestimmt wesentlich die Länge des Reaktionsrohrbereichs, welcher in der Figur 1 mit dem Bezugszeichen 20 bezeichnet ist, in dem ein homogener Niederschlag von Schichtmaterial stattfindet. (Weitere Parameter, welche die Länge der Reaktionszone mit einheitlicher Niederschlagsgeschwindigkeit beeinflussen, sind die freie Weglänge der Quellmaterialmoleküle und die Partialdrücke der Quellmaterialien). Legt man sich auf eine hohe Temperatur fest, so steigt die Reaktionsgeschwindigkeit stark an und der Niederschlagsbereich verkürzt sich infolgedessen. Umgekehrt sind die Verhältnisse, wenn eine niedrige Temperatur eingestellt wird, d.h. in diesem Fall ist der Niederschlagsbereich relativ lang. Wird die Temperatur auf 730° C eingestellt, so lassen sich eine Reaktionszone mit einheitlicher Niederschlaggeschwindigkeit, in der größenordnungsmäßig 50 Halbleiterplättchen ohne weiteres Platz finden, und eine brauchbare Niederschlagsgeschwindigkeit (größenordnungsmäßig 5 bis 25 nm) gleichzeitig verwirklichen.

Sind Reaktionsrohr und Substrate auf die festgelegte Temperatur erhitzt, wird das Ventil 8 geöffnet, so daß TEOS aus dem Quellenbehälter 1 in den Niederdruckbereich eingesaugt werden kann. Das Nadelventil 5 ist dabei so eingestellt, daß bevorzugt zwischen ungefähr 0,1 und ungefähr 1,0 cm³ flüssiges TEOS pro Minute in den Niederdruckbereich eingesaugt werden. Das eingesaugte flüssige Material beginnt sofort zu verdampfen. Da es wünschenswert ist, daß nur gasförmiges Material in den heißen Bereich des Reaktionsrohrs gelangt, ist es vorteilhaft, wenn die benutzte Vorrichtung den Vorerwärmer 9 aufweist, welcher bevorzugt auf eine Temperatur im Bereich zwischen etwa 100 und etwa 200° C aufgeheizt ist und eine vollständige Verdampfung des eingesaugten Materials sicherstellt. Ist die gewünschte Schichtdicke aufgewachsen, so wird der Prozess unterbrochen, indem das Ventil 8 geschlossen wird. Anschließend wird mit Stickstoff, der durch das Einleitungsrohr 15 eingelassen wird, gespült.

Die Homogenität der aufgewachsenen Schicht war über die Halbleiterplättchen ± 2 % und über die gesamte Charge, welche aus 53 Halbleiterplättchen bestand, ± 3 %. Die aufgewachsene Schicht besteht nicht aus reinem Siliciumdioxid. Vielmehr liegt der Sauerstoffgehalt unter dem stöchiometrischen Wert.

Soll die Schicht aus reinem Siliciumdioxid bestehen, ist es vorteilhaft, zusätzlich während des Niederschlagens durch das Einleitungsrohr 15 eine geringe Menge Sauerstoff in das Reaktionsrohr einzuleiten, damit der Sauerstoffanteil im Reaktionsgemisch etwas überstöchiometrisch ist. Beispielsweise liegt, wenn 0,2 cm$^3$ flüssiges TEOS pro Minute eingesaugt werden, eine brauchbare Menge bei 20 cm$^3$ Sauerstoffgas pro Minute (der Gesamtdampfdruck der Reaktanden erhöht sich dadurch im Niederschlagsbereich um etwa 70 $\mu$bar. Die gemäß dieser Variante des erfindungsgemäßen Verfahrens hergestellten Schichten sind genauso einheitlich dick wie die ohne den Sauerstoffzusatz hergestellten Schichten und auch bei ihnen werden keine Trübungen und keine Ausscheidungen festgestellt. Die Schichten sind außerdem nicht hygroskopisch, haben einen Brechungsindex n von 1,45 ± 0,02 und können thermisches Oxid ersetzen. Die erfindungsgemäß hergestellten Schichten können deshalb beispielsweise überall dort Verwendung finden, wo bisher bevorzugt thermisches Oxid eingesetzt wird, d.h. z.B. als Diffusionsmasken in der Halbleitertechnik und als Dielektrika auf Halbleiterbauteilen.

Im folgenden wird die Verwendung des erfindungsgemäßen Verfahrens bei der Herstellung von Schichten, welche außer Silicium und Sauerstoff mindestens noch ein weiteres Element, z.B. aus der Gruppe Arsen, Phosphor und Bor enthalten, besprochen. Es ist dabei praktisch dieselbe Vorrichtung wie bei der Herstellung von nur Silicium und Sauerstoff enthaltenden Schichten verwendbar.

Der wesentliche Unterschied zur oben beschriebenen Herstellung von nur Silicium und Sauerstoff enthaltenden Schichten ist dabei der, daß das flüssige Quellenmaterial außer TEOS auch noch flüssige Verbindungen der zusätzlich in die Schicht einzubauenden Elemente enthält. Als Quelle für Phosphor wird dabei bevorzugt Triethylphosphit (TEP), Trimethylphosphit, Triethylphosphat und Trimethylphosphat, als Quelle für Arsen Triethylarsenit (TEA) und als Quelle für Bor Trimethylborat (TMB), Triethylborat und Tripropylborat verwendet. Die Zusammensetzung des Quellenmaterials, die erforderlich ist, um eine bestimmte Schichtzusammensetzung zu erhalten, kann durch einfache Versuche ermittelt werden. Die Zusammensetzung des Quellenmaterials beeinflußt auch die Niederschlagsgeschwindigkeit. Beispielsweise nimmt die Niederschlagsgeschwindigkeit mit zunehmendem TEP-Gehalt ab und mit steigendem TMB-Gehalt zu. Enthält das Quellenmaterial sowohl TEP und TMB, dann hängt es vom Mengenverhältnis der beiden Verbindungen ab, ob die Niederschlagsgeschwindigkeit durch die Zusätze erhöht oder erniedrigt wird.

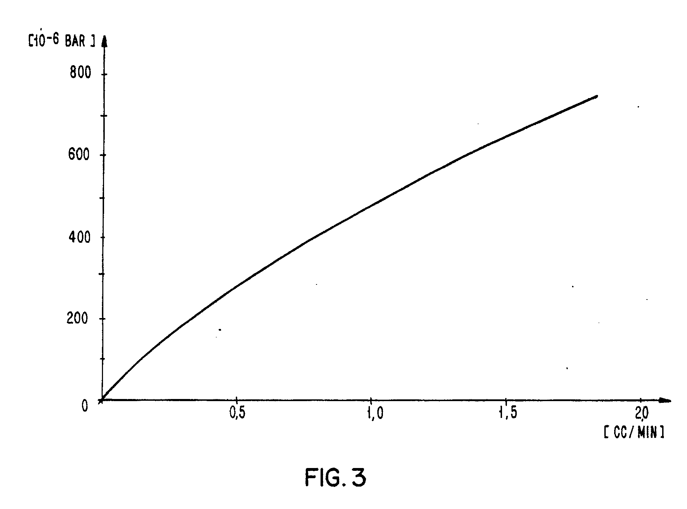

Die Temperatur des Niederschlagsbereichs wird bevorzugt auf einen Wert im Temperaturenbereich zwischen etwa 700 und etwa 750° C eingestellt. Die in den Niederdruckbereich der Vorrichtung eingesaugte Quellenmaterialmenge liegt bevorzugt im Bereich zwischen 0,2 und 1,7 cm$^3$ pro Minute, was - wie man der Kurve 1 in der Figur 3 entnehmen kann - für ein Quellenmaterial, welches außer TEOS 12,6 Gewichtsprozent TMB und 14,7 Gewichtsprozent TEP enthält, einem Partialdruckbereich des Quellenmaterialgemischs im Niederschlagsbereich zwischen etwa 133 und etwa 693 $\mu$bar entspricht. Unter diesen Bedingungen werden auf den Substraten Glasschichten niedergeschlagen. Die Homogenität der Schichtdicke über ein Substrat, beispielsweise ein Halbleiterplättchen von 100 mm Durchmesser liegt bei ± 3,5 % und über die Charge, welche größenordnungsmäßig 50 Halbleiterplättchen umfassen kann, ± 5,5 %.

Es ist günstig, wenn die Reaktionsmischung einen Sauerstoffanteil enthält, der etwas größer ist als der stöchiometrisch für die Bildung der beständigsten Oxide des Siliciums und der zusätzlichen Elemente erforderliche. Deshalb wird bevorzugt als zusätzliches Quellenmaterial noch Sauerstoff in das Reaktionsrohr eingeleitet. Die eingeleitete Sauerstoffmenge liegt typischerweise zwischen etwa 100 und 250 cm$^3$ pro Minute (dadurch gehöht sich der Gesamtdruck der Reaktanden im Niederschlagsbereich um zwischen 240 und 600 $\mu$bar). Abgesehen von der Sauerstoffzugabe sind die übrigen Niederschlagsbedingungen dieselben wie bei der Verfahrensdurchführung ohne Sauerstoffzusatz. Die mittels dieser Variante des erfindungsgemäßen Verfahrens hergestellten Schichten haben nicht nur die gewünschte "stöchiometrische" Zusammensetzung, vielmehr zeichnen sie sich auch noch durch eine sehr homogene Zusammensetzung, sowohl über die Substrate als auch über die ganze Charge, aus und die Schichtenhomogenität ist ebenso wie beim Prozessieren ohne Sauerstoffzusatz ± 3,5 % über die Substrate (in Form von Halbleiterplättchen mit 100 mm Durchmesser) und ± 5,5 % über die ganze aus größenordnungsmäßig 50 Halbleiterplättchen bestehende Charge. Die erzeugten Schichten bestehen aus Glas und sind schmelzbar.

Sie zeigen keine Trübung und keine Ausscheidungen. Ihr Brechungsindex n liegt im Bereich zwischen etwa 1,44 und etwa 1,45. Außerdem haben die Schichten sowohl beim Naß- als auch beim Plasmaätzen über die Dicke der Schicht eine gleichförmige Ätzgeschwindigkeit. Schichten, die außer Silicium und Sauerstoff noch Bor und Phosphor enthalten, werden benutzt zur Passivierung und Planarisierung von Halbleiteroberflächen. Schichten, welche außer Silicium und Sauerstoff Bor oder Phosphor oder Arsen, d.h. nur ein zusätzliches Element, enthalten, werden außer zum Passivieren und Planarisieren von Halbleiteroberflächen auch noch als Diffusionsquellen beim Dotieren von Halbleitermaterial mit den genannten Elementen durch Diffusion eingesetzt.

Im folgenden soll anhand von zwei Beispielen das erfindungsgemäße Verfahren noch mehr verdeutlicht werden. Im ersten Beispiel wird die Herstellung einer Siliciumdioxidschicht und im zweiten Beispiel die Herstellung eines Glases, welches Phosphoroxid, Boroxid und Siliciumdioxid enthält, beschrieben.

Bei den Beispielen waren die folgenden Bedingungen gleich: Es wurde eine Vorrichtung benutzt, wie sie die Figur 1 in schematischer Darstellung wiedergibt. Der Durchmesser des Reaktionsrohrs lag bei etwa 180 mm und es war 200 cm lang (Länge des Rohrofens = 180 cm). Die Temperatur im Niederschlagsbereich wurde auf 730° C eingestellt. Der Reaktionsmischung wurde Sauerstoff zugefügt. Beschichtet wurden 50 Halbleiterplättchen mit einem Durchmesser von 100 mm, welche senkrecht zur Saugrichtung in drei Quarzbooten in einer 60 cm langen Reaktionszone standen. Die Verdampfung der flüssigen Quellmaterialien wurde unterstützt durch den auf 120° C erhitzten Vorverdampfer 9.

Beispiel 1

Zunächst wurde der Niederdruckbereich evakuiert und das Reaktionsrohr mit den Halbleiterplättchen auf die festgelegte Temperatur erhitzt. Anschließend wurden pro Minute 0,2 cm$^3$ TEOS (entsprechend einem Partialdruck im Niederschlagsbereich von ungefähr 130 $\mu$bar) in den Niederdruckbereich eingesaugt und 20 cm$^3$ Sauerstoff (durch dessen Zusatz erhöht sich der Gesamtdruck der Reaktanden im Niederschlagsbereich um ungefähr 70 $\mu$bar) in das Reaktionsrohr eingeleitet. Die Aufwachsgeschwindigkeit der Siliciumdioxidschicht war ungefähr 15 nm pro Minute. Es wurde eine Stunde lang aufgewachsen. Die aufgewachsene SiO$_2$-Schicht war 900 mm dick, wobei die Schwankungen in dem oben angegebenen Bereich von ± 2 % über die Halbleiterplättchen und ± 3 % über die gesamte Charge lagen. Die auf den Halbleiterplättchen aufgewachsene Schicht hatte die oben beschriebenen Eigenschaften.

Beispiel 2

In den Quellenbehälter 1 wurde eine Quellenmaterialmischung, welche 14,7 Gewichtsprozent TEP, 12,6 Gewichtsprozent TMB und 72,7 Gewichtsprozent TEOS enthielt, eingefüllt. Nachdem der Niederdruckbereich evakuiert und das Reaktionsrohr mit den Halbleiterplättchen auf die festgelegte Temperatur gebracht worden war, wurden pro Minute 0,7 cm$^3$ (entsprechend einem Partialdruck im Niederschlagsbereich von ungefähr 360 $\mu$bar) in den Niederdruckbereich eingesaugt und 100 cm$^3$ Sauerstoff (durch diesen Zusatz resultiert ein Gesamtdampfdruck der Reaktanten im Niederdruckbereich von etwa 600 $\mu$bar) in das Reaktionsrohr eingeleitet. Die Aufwachsgeschwindigkeit der Schicht lag bei ungefähr 15 nm pro Minute. Es wurde eine Stunde aufgewachsen. Die auf den Halbleiterplättchen aufgewachsene Schicht hatte eine Dicke von 900 nm, wobei die Schwankung der Schichtdicke über die Halbleiterplättchen ± 3,5 % und über die eingesetzten 50 Halbleiterplättchen bei ± 5,5 % lagen. Die aufgewachsene Glasschicht enthielt 2,5 Gewichtsprozent Phosphor und 4 Gewichtsprozent Bor. Die Homogenität der Zusammensetzung über die Halbleiterplättchen und die gesamte Charge war ausgezeichnet. Im übrigen hatte die auf den Halbleiterplättchen aufgewachsene Glasschicht die oben beschriebenen Eigenschaften.

**Patentansprüche**

1. Verfahren zum Herstellen von Silicium und Sauerstoff enthaltenden Schichten mittels chemischen Niederschlagens aus der Dampfphase auf Substrate (17) bei vermindertem Druck, wobei als Quelle für Silicium und Sauerstoff dienendes Tetraethylorthosilikat (TEOS) (2) über die auf eine festgelegte Temperatur erhitzten Substrate (17) geleitet wird, dadurch gekennzeichnet, daß das TEOS (2) nur in flüssiger Form in den Niederdruckbereich der Niederschlagsapparatur eingesaugt und erst dort verdampft wird, wobei der Dampfdruck des TEOS in der auf eine festgelegte Temperatur aufgeheizten Reaktionszone (10) über die flüssige TEOS-Menge gesteuert wird, die pro Zeiteinheit eingesaugt wird, indem im wesentlichen gleiche Mengen TEOS verdampft wie eingesaugt werden.

2. Verfahren nach Patentanspruch 1, dadurch gekennzeichnet, daß zusätzlich Sauerstoff über die Substrate (17) geleitet wird.

3. Verfahren nach Patentanspruch 1 oder 2, dadurch gekennzeichnet, daß bei festgelegter Temperatur die Abscheidungsgeschwindigkeit über den Partialdruck der Quellmaterialien im Niederschlagsbereich gesteuert wird.

4. Verfahren nach einem der Ansprüche 1 bis 3, dadurch gekennzeichnet, daß bei Temperaturen im Bereich zwischen etwa 700 und etwa 750° C und bevorzugt bei etwa 730° C aufgewachsen wird.

5. Verfahren nach einem der Ansprüche 1 bis 4, dadurch gekennzeichnet, daß zum Aufwachsen von SiO$_2$-Schichten flüssige TEOS-Mengen im Bereich zwischen etwa 0,1 und etwa 1,0 cm$^3$ pro Minute in den Niederdruckbereich eingesaugt werden und zusätzlich Sauerstoff in einer solchen Menge eingeleitet wird, daß der Sauerstoffanteil in dem Reaktionsgemisch etwas überstöchiometrisch ist.

6. Verfahren nach Patentanspruch 5, dadurch gekennzeichnet, daß in den Niederdruckbereich 0,2 cm$^3$ TEOS pro Minute eingesaugt und 20 cm$^3$ Sauerstoff pro Minute in den Niederdruckbereich eingeleitet werden.

7. Verfahren nach einem der Ansprüche 1 bis 4, dadurch gekennzeichnet, daß zum Aufwachsen von Schichten, welche außer Silicium und Sauerstoff noch mindestens ein weiteres Element enthalten, dem flüssigen TEOS eine flüssige Verbindung des weiteren Elements bzw. flüssige Verbindungen der weiteren Elemente in Mengen zugemischt wird bzw. werden, welche durch die gewünschte Zusammensetzung der aufwachsenden Schicht festgelegt sind.

8. Verfahren nach Anspruch 7, dadurch gekennzeichnet, daß mindestens eine Verbindung aus der Gruppe Triethylphosphit (TEP), Triethylarsenit (TEAs) und Trimethylborat (TMB) zugemischt wird.

9. Verfahren nach Anspruch 7 oder 8, dadurch gekennzeichnet, daß zum Aufwachsen von Schichten, welche außer Silicium und Sauerstoff noch mindestens ein weiteres Element enthalten, in den Niederdruckbereich flüssige Quellmaterialmengen im Bereich zwischen 0,2 und 1,7 cm$^3$ pro Minute, entsprechend einem Partialdruck im Niederschlagsbereich zwischen etwa 130 und etwa 700 μbar, gesaugt und Sauerstoff in solchen Mengen eingeleitet werden, daß der Sauerstoffanteil in der Reaktionsmischung etwas größer ist als der stöchiometrisch für die Bildung der beständigsten Oxide des Siliciums und des zusätzlichen Elements bzw. der zusätzlichen Elemente erforderliche.

10. Verfahren nach einem der Ansprüche 7 bis 9, dadurch gekennzeichnet, daß zum Aufwachsen einer Glasschicht, welche etwa 2 Gewichtsprozent Phosphor und etwa 4 Gewichtsprozent Bor enthält, etwa 0,7 cm$^3$ eines Quellenmaterials pro Minute eingesaugt wird, welches aus 72,7 Gewichtsprozent TEOS, 14,7 Gewichtsprozent TEP und 12,6 Gewichtsprozent TMB besteht, und etwa 100 cm$^3$ Sauerstoff pro Minute eingeleitet werden.

## Claims

1. Method of forming silicon and oxygen containing layers by chemical vapor deposition on substrates (17) at reduced pressure, wherein tetraethylorthosilicate (TEOS) (2), serving as a source for silicon and oxygen, is directed over the substrates (17) which have been heated to a predetermined temperature, characterized in that the TEOS (2) is sucked into the low-pressure area of the deposition apparatus only in liquid form and evaporated only there, with the vapor pressure of the TEOS in the reaction zone (10), heated to a predetermined temperature, being controlled as a function of the liquid TEOS quantity sucked in per unit of time by evaporating and sucking in substantially identical quantities of TEOS.

2. Method as claimed in claim 1, characterized in that oxygen is additionally directed over the substrates (17).

3. Method as claimed in claims 1 or 2, characterized in that at a predetermined temperature the deposition speed is controlled via the partial pressure of the source materials in the deposition area.

4. Method as claimed in any one of claims 1 to 3, characterized in that the growing process is implemented at temperatures between approx. 700 and approx. 750° C, and preferably at approx. 730° C.

5. Method as claimed in any one of claims 1 to 4, characterized in that for growing SiO$_2$ layers liquid TEOS quantities between approx. 0.1 and approx. 1.0 cm$^3$ per minute are sucked into the low pressure area and that additionally oxygen is introduced in such a quantity that the oxygen percentage in the reactant mixture is slightly over-stoichiometric.

**6.** Method as claimed in claim 5, characterized in that 0.2 cm$^3$ TEOS per minute are sucked into the low pressure area, and in that 20 cm$^3$ oxygen per minute are introduced into the low pressure area.

**7.** Method as claimed in any one of claims 1 to 4, characterized in that for growing layers which apart from silicon and oxygen comprise at least one further element a liquid compound of the further element, or liquid compounds of the further elements is or are admixed to the liquid TEOS in quantities predetermined by the desired composition of the grown layer.

**8.** Method as claimed in claim 7, characterized in that at least one compound selected from the group of triethylphosphite (TEP), triethylarsenite (TEAs) and trimethylborate (TMB) is admixed.

**9.** Method as claimed in claim 7 or 8, characterized in that for growing layers comprising except silicon and oxygen at least one further element liquid source materials between 0.2 and 1.7 cm$^3$ per minute, corresponding to a partial pressure in the deposition area between approx. 130 and approx. 700 $\mu$bar, are sucked into the low pressure area, and that oxygen is introduced in such quantities that the oxygen percentage in the reaction mixture is slightly greater than that required stoichiometrically for forming the most stable oxides of the silicon and of the additional element or elements.

**10.** Method as claimed in any one of claims 7 to 9, characterized in that for growing a glass layer comprising approx. 2 percent by weight phosphorus and approx. 4 percent by weight boron approx. 0.7 cm$^3$ of a source material per minute is sucked in which consists of 72.7 percent by weight TEOS, 14.7 percent by weight TEP and 12.6 percent by weight TMB, and that approx. 100 cm$^3$ oxygen per minute are introduced.

**Revendications**

**1.** Procédé de fabrication de couches contenant du silicium et de l'oxygène, par précipitation chimique en phase vapeur sur des substrats (17), sous pression réduite, dans lequel on dirige du tétraéthylorthosilicate (TEOS) (2), comme source de silicium et d'oxygène, sur le substrat (17) chauffé à une température définie, caractérisé en ce que le TEOS (2) est aspiré dans la zone de basse pression de l'appareil de précipitation uniquement à l'état liquide et c'est seulement là qu'il est vaporisé, la pression de vapeur du TEOS dans la zone de réaction (10) chauffée à une température définie étant commandée par la quantité de TEOS liquide qui est aspirée par unité de temps, en ce que des quantités de TEOS égales en substance sont vaporisées et aspirées.

**2.** Procédé selon la revendication 1, caractérisé en ce qu'on dirige en outre de l'oxygène sur les substrats (17).

**3.** Procédé selon la revendication 1 ou 2, caractérisé en ce que, à la température définie, la vitesse de précipitation est commandée par la pression partielle des produits de base dans la zone de précipitation.

**4.** Procédé selon l'une des revendications 1 à 3, caractérisé en ce qu'il est réalisé à des températures comprises entre environ 700 et environ 750° C, et de préférence à environ 730° C.

**5.** Procédé selon l'une des revendications 1 à 4, caractérisé en ce que, pour former des couches de SiO$_2$, des quantités de TEOS liquide sont aspirées, à raison d'environ 0,1 à environ 1,0 cm$^3$ par minute, dans la zone de basse pression, et on dirige en outre de l'oxygène en quantité telle que la proportion d'oxygène du mélange réactionnel est légèrement supérieure à la quantité stoechiométrique.

**6.** Procédé selon la revendication 5, caractérisé en ce que 0,2 cm$^3$ de TEOS par minute sont aspirés dans la zone de basse pression et 20 cm$^3$ d'oxygène par minute sont introduits dans la zone de basse pression.

**7.** Procédé selon l'une des revendications 1 à 4, caractérisé en ce que, pour former des couches qui, en plus du silicium et de l'oxygène, contiennent au moins un autre élément, on ajoute au TEOS liquide un composé liquide de l'élément supplémentaire, ou des composés liquides des éléments supplémentaires, avec des quantités qui sont déterminées par la composition souhaitée pour la couche formée.

**8.** Procédé selon la revendication 7, caractérisé en ce qu'on ajoute au moins un composé du groupe triéthylphosphite (TEP), triéthylarsénite (TEAs) ou triméthylborate (TMB).

**9.** Procédé selon la revendication 7 ou 8, caractérisé en ce que, pour former des couches qui, en plus du silicium et de l'oxygène, contiennent au moins un autre élément, des quantités de produits de base liquides sont aspirées dans la zone de basse pression à raison de 0,2 à 1,7 cm³ par minute, ce qui correspond à une pression partielle d'environ 130 à environ 700 μbar dans la zone de précipitation, et on introduit de l'oxygène en quantités telles que la proportion d'oxygène du mélange réactionnel est légèrement supérieure à la quantité stoechiométrique qui est nécessaire à la formation des oxydes les plus résistants de silicium et de l'élément ou des éléments supplémentaire(s).

10. Procédé selon l'une des revendications 1 à 9, caractérisé en ce que, pour former une couche vitreuse qui contient environ 2 % en poids de phosphore et environ 4 % en poids de bore, environ 0,7 cm³ d'une matière de base sont aspirés par minute, qui est composée de 72,7 % en poids de TEOS, 14,7 % en poids de TEP et 12,6 % en poids de TMB, et on injecte environ 100 cm³ d'oxygène par minute.

FIG. 1

FIG. 2

FIG. 3